# EUROPEAN PATENT APPLICATION

(11) **EP 4 521 455 A1**
(43) Date of publication of application: **12.03.2025**
(21) Application number: 24198129.9
(22) Date of filing: 03.09.2024
(51) Int. Cl.: H01L 23/31, H01L 23/00

(54) **POWER MODULE**

(30) Priority: 06.09.2023 CN 202311148151
(71) Applicant: Huawei Digital Power Technologies Co., Ltd., Shenzhen, Guangdong 518043 (CN)
(72) Inventor: LIU, Yumin, Shenzhen, 518043 (CN); YUAN, Bo, Shenzhen, 518043 (CN); CHEN, Yue, Shenzhen, 518043 (CN); YAFEI, Lv, Shenzhen, 518043 (CN)
(74) Representative: Gill Jennings & Every LLP

(57) **Abstract**

This application provides a power module, including: a chip, a package baseplate, a ceramic baseplate, and a plastic package body. The chip is disposed on the ceramic baseplate, the package baseplate is disposed on a surface that is of the ceramic baseplate and that is away from the chip, and an area of the package baseplate is greater than an area of the ceramic baseplate. The package baseplate includes at least one protrusion structure, the at least one protrusion structure is located on a surface that is of the package baseplate and that is close to the ceramic baseplate, and projection of the at least one protrusion structure does not overlap projection of the ceramic baseplate in a thickness direction of the chip. The chip, the ceramic baseplate, and the surface that is of the package baseplate and on which the at least one protrusion structure is disposed are disposed in the plastic package body. Based on the foregoing technical solutions, problems of delamination and cracking between the package baseplate and the plastic package body can be resolved.

## Description

### TECHNICAL FIELD

This application relates to the field of chip packaging, and specifically, to a power module.

### BACKGROUND

A plastic package body in a power module can protect a semiconductor chip from being affected by an external environment (for example, water vapor, temperature, and pollution), and implement important composite functions such as heat conduction, insulation, moisture resistance, voltage resistance, and support. In a plastic packaging process, an epoxy molding compound (epoxy molding compound, EMC) is usually extruded into a mold cavity through transfer injection molding to embed the semiconductor chip in the mold cavity. After being cross-linked with a package baseplate (the package baseplate may also be referred to as a baseplate (baseplate, BP)) and solidified in the mold cavity, the epoxy molding compound becomes a semiconductor device of a specific structure.

After the plastic package body is solidified, there is specific bonding force between the plastic package body and the package baseplate, so that the plastic package body and the package baseplate are integrated. However, when the bonding force is insufficient, delamination and cracking between the package baseplate and the plastic package body. In this case, the plastic package body cannot effectively protect the power module, causing damage and failure of the power module.

Based on this, this application aims to provide a power module, to resolve problems of delamination and cracking between the package baseplate and the plastic package body.

### SUMMARY

This application provides a power module, to resolve problems of delamination and cracking between a package baseplate and a plastic package body.

According to a first aspect, a power module is provided. The power module includes a chip, a package baseplate, a ceramic baseplate, and a plastic package body. The chip is disposed on the ceramic baseplate, the package baseplate is disposed on a surface that is of the ceramic baseplate and that is away from the chip, and an area of the package baseplate is greater than an area of the ceramic baseplate. The package baseplate includes at least one protrusion structure, the at least one protrusion structure is located on a surface that is of the package baseplate and that is close to the ceramic baseplate, and projection of the at least one protrusion structure does not overlap projection of the ceramic baseplate in a thickness direction of the chip. The chip, the ceramic baseplate, and the surface that is of the package baseplate and on which the at least one protrusion structure is disposed are disposed in the plastic package body.

In this embodiment of this application, the at least one protrusion structure is disposed on the surface that is of the package baseplate and that is close to the ceramic baseplate, and the chip, the ceramic baseplate, and the surface that is of the package baseplate and on which the at least one protrusion structure is disposed are disposed in the plastic package body, so that bonding force between the package baseplate and the plastic package body can be further increased, to resolve problems of delamination and cracking between the package baseplate and the plastic package body.

With reference to the first aspect, in some implementations of the first aspect, the package baseplate includes a rough structure, and the rough structure is disposed on a part, not covered by the ceramic baseplate, of the surface that is of the package baseplate and that is close to the ceramic baseplate. Based on the foregoing technical solutions, the bonding force between the package baseplate and the plastic package body can be further increased, to resolve the problems of delamination and cracking between the package baseplate and the plastic package body.

With reference to the first aspect, in some implementations of the first aspect, the at least one protrusion structure is disposed on at least one side of the ceramic baseplate. Based on the foregoing technical solutions, the bonding force between the package baseplate and the plastic package body can be further increased, to resolve the problems of delamination and cracking between the package baseplate and the plastic package body.

With reference to the first aspect, in some implementations of the first aspect, the at least one protrusion structure is arranged in at least one of the following shapes:
a straight line shape, a fold line shape, an arc shape, a wave shape, and a circular shape. Based on the foregoing technical solutions, the bonding force between the package baseplate and the plastic package body can be further increased, to resolve the problems of delamination and cracking between the package baseplate and the plastic package body.

With reference to the first aspect, in some implementations of the first aspect, the at least one protrusion structure is arranged in a single-row arrangement manner or a multi-row arrangement manner. Based on the foregoing technical solutions, the bonding force between the package baseplate and the plastic package body can be further increased, to resolve the problems of delamination and cracking between the package baseplate and the plastic package body.

With reference to the first aspect, in some implementations of the first aspect, the package baseplate includes at least one groove structure, and the at least one groove structure is disposed on the part, not covered by the ceramic baseplate, of the surface that is of the package baseplate and that is close to the ceramic baseplate. Based on the foregoing technical solutions, the bonding force between the package baseplate and the plastic package body can be further increased, to resolve the problems of delamination and cracking between the package baseplate and the plastic package body.

With reference to the first aspect, in some implementations of the first aspect, the at least one protrusion structure is disposed between any two adjacent groove structures in the at least one groove structure. Based on the foregoing technical solutions, the bonding force between the package baseplate and the plastic package body can be further increased, to resolve the problems of delamination and cracking between the package baseplate and the plastic package body.

With reference to the first aspect, in some implementations of the first aspect, a cross section of the groove structure includes at least one of the following shapes: a circle, an ellipse, a triangle, and a polygon. Based on the foregoing technical solutions, the bonding force between the package baseplate and the plastic package body can be further increased, to resolve the problems of delamination and cracking between the package baseplate and the plastic package body.

With reference to the first aspect, in some implementations of the first aspect, the at least one protrusion structure includes at least one of the following: a cylinder, a prism, a cuboid, and a cube. Based on the foregoing technical solutions, the bonding force between the package baseplate and the plastic package body can be further increased, to resolve the problems of delamination and cracking between the package baseplate and the plastic package body.

With reference to the first aspect, in some implementations of the first aspect, an interface area of a side that is of the at least one protrusion structure and that is close to the package baseplate is less than an interface area of a side that is of the at least one protrusion structure and that is away from the package baseplate, or an interface area of a side that is of the at least one protrusion structure and that is close to the package baseplate is greater than an interface area of a side that is of the at least one protrusion structure and that is away from the package baseplate. Based on the foregoing technical solutions, the bonding force between the package baseplate and the plastic package body can be further increased, to resolve the problems of delamination and cracking between the package baseplate and the plastic package body.

According to a second aspect, a power supply apparatus is provided. The power supply apparatus includes a circuit board and the power module according to the first aspect and some implementations of the first aspect. The power module is disposed on the circuit board.

### BRIEF DESCRIPTION OF DRAWINGS

FIG. 1 is a diagram of a structure of a power supply apparatus according to an embodiment of this application;
FIG. 2 is a diagram of a structure of a power module according to an embodiment of this application;
FIG. 3 is a top view of a power module according to an embodiment of this application;
FIG. 4 is a diagram of structures of disposing positions of a protrusion structure according to an embodiment of this application;
FIG. 5 is a diagram of structures of disposing positions of at least one protrusion structure according to an embodiment of this application;
FIG. 6 is a diagram of structures of disposing positions of at least one protrusion structure according to an embodiment of this application; and
FIG. 7 is a diagram of structures of a baseplate on which a protrusion structure and a groove structure are disposed according to an embodiment of this application.

### Reference numerals:

100-power supply apparatus; 110-power module; 120-power-consuming device; 200-power module; 210-chip; 220-package baseplate; 230-ceramic baseplate; 240-protrusion structure; 250-plastic package body; 310-first region; 320-second region; 710-groove structure.

### DESCRIPTION OF EMBODIMENTS

The following describes technical solutions of this application with reference to accompanying drawings.

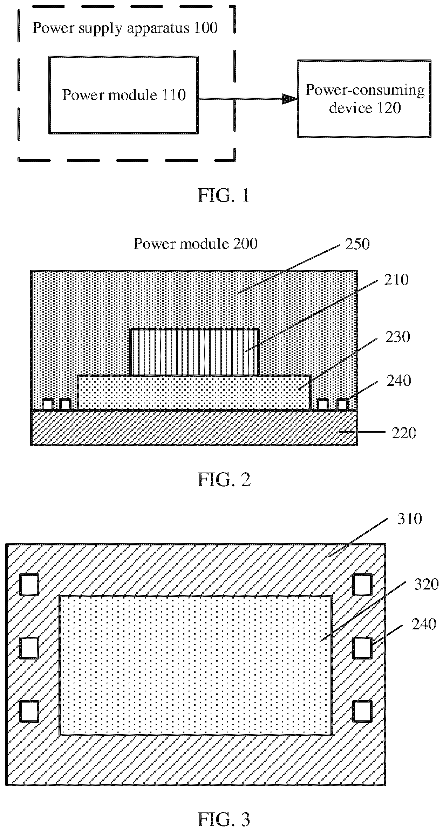

FIG. 1 is a diagram of a structure of a power supply apparatus 100 according to an embodiment of this application. As shown in FIG. 1, the power supply apparatus 100 includes a housing (not shown in the figure) of the power supply apparatus 100, a printed circuit board (printed circuit board, PCB) (not shown in the figure), and a power module 110.

The power module 110 is disposed in the housing, the housing is configured to protect the power module 110, and the power module 110 is disposed on the PCB board. Further, an output end of the power supply apparatus 100 is coupled to a power-consuming device 120.

It should be noted that the power-consuming device 120 may be a load that requires a direct current input, for example, a terminal or an electric vehicle, or the power-consuming device 120 may be a load that requires an alternating current input. It should be understood that this is not limited in embodiments of this application.

It should be noted that "coupling" described in this application indicates a direct or indirect connection. For example, that A is coupled to B may be that A is directly connected to B, or may be that A is indirectly connected to B through one or more other electrical components, for example, A is directly connected to C and C is directly connected to B, to implement a connection between A and B via C.

For ease of understanding, the following explains technical terms in this application.
1. A direct bond copper (direct bond copper, DBC) ceramic baseplate is a metallization method for bonding copper foil on a ceramic surface (mainly aluminum oxide and aluminum nitride), and is a new process developed with the rise of a chip-on-board (chip-on-board, COB) packaging technology.
2. A direct bonded aluminum (direct bonded aluminum, DBA) ceramic baseplate is a high-heat-dissipation insulation baseplate formed by bonding high-purity aluminum circuits on two sides of ceramics. The baseplate is characterized by high reliability for temperature cycling, which comes from a unique bonding technology of ceramics and aluminum.

FIG. 2 is a diagram of a structure of a power module 200 according to an embodiment of this application.

As shown in FIG. 2, the power module 200 includes a chip 210, a package baseplate 220, a ceramic baseplate 230, and a plastic package body 250.

The package baseplate 220 includes a first surface and a second surface that are disposed opposite to each other (generally, the first surface of the package baseplate 220 is parallel to the second surface of the package baseplate 220). In this application, as a part of the power module, the package baseplate 220 is connected to solidified plastic package body 250 through bonding force to form a whole. For example, the package baseplate 220 may be a copper baseplate, or may be an aluminum baseplate, or may be a baseplate made of another non-metallic material. It should be understood that this is not limited in embodiments of this application.

The ceramic baseplate 230 is configured to carry the chip 210. Specifically, the chip 210 is disposed on the ceramic baseplate 230, the package baseplate 220 is disposed on a surface that is of the ceramic baseplate 230 and that is away from the chip 210, and an area of the package baseplate 220 is greater than an area of the ceramic baseplate 230.

FIG. 3 is a top view of the power module 200 according to an embodiment of this application. The area of the package baseplate 220 being greater than the area of the ceramic baseplate 230 may be understood that the surface that is of the ceramic baseplate 230 and that is close to the package baseplate 220 is in contact with a partial area (for example, a second region 320 shown in FIG. 3) of a surface (for example, the first surface) of the package baseplate 220.

In this application, the ceramic baseplate 230 may be a DBC ceramic baseplate, or may be a DBA ceramic baseplate, or may be a ceramic baseplate of another material. It should be understood that this is not limited in embodiments of this application.

The ceramic baseplate 230 (for example, the DBC ceramic baseplate or the DBA ceramic baseplate) is electrically connected, through a surface copper-clad layer or a surface aluminum-clad layer, to the chip 210 carried on the ceramic baseplate 230.

It should be noted that the ceramic baseplate 230 and the package baseplate 220 may be fastened through welding, or the ceramic baseplate 230 and the package baseplate 220 may be fastened by using a bonding material, or the ceramic baseplate 230 and the package baseplate 220 may be fastened with screws, or the ceramic baseplate 230 and the package baseplate 220 may be fastened through sintering (for example, copper sintering or silver sintering). It should be understood that this is not limited in embodiments of this application.

The bonding material may be, for example, patch adhesive. It should be understood that any material that can implement a bonding function is applicable to this embodiment of this application. It should be further understood that a specific material of the patch adhesive is not limited in embodiments of this application. By way of example and not limitation, the patch adhesive may be any one of the following materials: epoxy resin, substitute resin, metal solder, glass powder, and the like.

Still refer to FIG. 2 and FIG. 3. The package baseplate 220 includes at least one protrusion structure 240. The at least one protrusion structure 240 is located on a surface that is of the package baseplate 220 and that is close to the ceramic baseplate 230, and projection of the at least one protrusion structure 240 does not overlap projection of the ceramic baseplate 230 in a thickness direction of the chip 210.

The at least one protrusion structure 240 is located on the surface that is of the package baseplate 220 and that is close to the ceramic baseplate 230, and the projection of the at least one protrusion structure 240 does not overlap the projection of the ceramic baseplate 230 in the thickness direction of the chip 210. It may be understood that the at least one protrusion structure 240 is disposed on a first region 310 of the package baseplate 220.

It should be noted that the first region 310 is an area on the first surface of the package baseplate 220 other than the second region 320, or it may be understood that the first region 310 is a region that is on the first surface of the package baseplate 220 and that is not covered by the ceramic baseplate, or it may be understood that the first region 310 is a region that is on the first surface of the package baseplate 220 and that is not in contact with the ceramic baseplate.

Optionally, in a possible implementation, an interface area of a side that is of the at least one protrusion structure 240 and that is close to the package baseplate 220 is less than an interface area of a side that is of the at least one protrusion structure 240 and that is away from the package baseplate 220.

Optionally, in a possible implementation, an interface area of a side that is of the at least one protrusion structure 240 and that is close to the package baseplate 220 is greater than an interface area of a side that is of the at least one protrusion structure 240 and that is away from the package baseplate 220. For example, the at least one protrusion structure 240 may be a prism, for example, a triangular prism or a quadrangular prism.

Optionally, in a possible implementation, an interface area of a side that is of the at least one protrusion structure 240 and that is close to the package baseplate 220 is equal to an interface area of a side that is of the at least one protrusion structure 240 and that is away from the package baseplate 220. For example, the at least one protrusion structure 240 may be a cylinder, a cube, or the like.

Specifically, the protrusion structure 240 may include at least one of the following: a cylinder, a prism, a cuboid, and a cube. The protrusion structure 240 may alternatively include an irregular protrusion structure 240. It should be understood that any protrusion structure 240 having a specific height is applicable to this embodiment of this application.

Optionally, in a possible implementation, the protrusion structure 240 may alternatively be a surface rough structure formed by performing roughening processing on the first region 310 of the package baseplate 220.

It should be noted that, the protrusion structure 240 may alternatively being the surface rough structure formed by performing surface roughening processing on the first region 310 of the package baseplate 220 may be understood that the protrusion structure 240 may alternatively be a micron-level protrusion structure that is on the surface of the package baseplate 220 and that is formed by performing surface roughening processing on the first region 310 of the package baseplate 220.

For example, roughness of the surface rough structure ranges from 10 µm to 100 µm. It should be understood that the foregoing range of the surface roughness is merely an example for description. This is not limited in embodiments of this application.

Further, as shown in FIG. 2, the chip 210, the ceramic baseplate 230, and the surface that is of the package baseplate 220 and on which the at least one protrusion structure is disposed are all disposed in the plastic package body 250 (or may also be referred to as the plastic package material 250).

Specifically, the plastic package body 250 covers the chip 210, the ceramic baseplate 230, and the surface that is of the package baseplate 220 and on which the at least one protrusion structure 240 is disposed, and fills gaps between the chip 210, the ceramic baseplate 230, and the surface that is of the package baseplate 220 and on which the at least one protrusion structure 240 is disposed, to isolate the chip 210 from the outside, and implement functions of moisture prevention, pollution prevention, and buffering. In addition, after being solidified, the plastic package body 250 can be combined with the package baseplate 220 to form a whole. This effectively protects the power module.

It should be noted that, the plastic package body 250 covering the chip 210, the ceramic baseplate 230, and the surface that is of the package baseplate 220 and on which the at least one protrusion structure 240 is disposed may be understood as follows: The plastic package body 250 covers an upper surface (a surface that is of the chip 210 and that is away from the ceramic baseplate 230) of the chip 210, an upper surface (a surface that is of the ceramic baseplate 230 and that is away from the package baseplate 220) of the ceramic baseplate 230, the surface that is of the package baseplate 220 and on which the at least one protrusion structure 240 is disposed, and an upper surface (a surface that is of each protrusion structure 240 and that is away from the package baseplate 220) of each protrusion structure 240 in the at least one protrusion structure 240, and the plastic package body 250 surrounds side surfaces of the chip 210, side surfaces of the ceramic baseplate 230, and side surfaces of each protrusion structure 240 in the at least one protrusion structure 240.

It should be further noted that in this application, the protrusion structure 240 may be prepared through forging, or the protrusion structure 240 may be prepared through welding, or the protrusion structure 240 may be prepared through computer numerical control (computer numerical control, CNC) machining. It should be understood that a preparation method of the protrusion structure 240 is not limited in embodiments of this application.

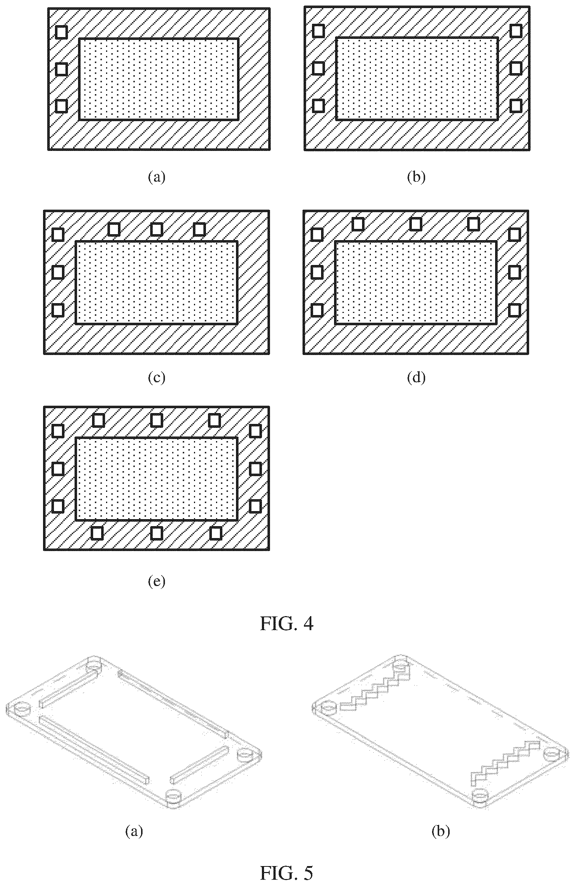

FIG. 4 is a diagram of structures of disposing positions of a protrusion structure 240 according to an embodiment of this application.

As shown in FIG. 4, the at least one protrusion structure 240 being disposed on at least one side of the ceramic baseplate 230 may be understood that the at least one protrusion structure 240 is disposed on at least one side of the first region 310 of the package baseplate 220. For specific descriptions of the first region 310, refer to the foregoing descriptions. For brevity, details are not described herein again.

Optionally, the at least one protrusion structure 240 is disposed on any side of the ceramic baseplate 230. For example, as shown in (a) in FIG. 4, the at least one protrusion structure 240 is disposed on any side of the first region 310 of the package baseplate 220.

Optionally, the at least one protrusion structure 240 is disposed on two adjacent sides or two opposite sides of the ceramic baseplate 230. For example, as shown in (b) and (c) in FIG. 4, the at least one protrusion structure 240 is disposed on two adjacent sides or two opposite sides of the first region 310 of the package baseplate 220.

Optionally, the at least one protrusion structure 240 is disposed on any three sides of the ceramic baseplate 230. For example, as shown in (d) in FIG. 4, the at least one protrusion structure 240 is disposed on any three sides of the first region 310 of the package baseplate 220.

Optionally, the at least one protrusion structure 240 is disposed on four sides of the ceramic baseplate 230. For example, as shown in (e) in FIG. 4, the at least one protrusion structure 240 is disposed on four sides of the first region 310 of the package baseplate 220.

Optionally, in a possible implementation, the at least one protrusion structure 240 disposed on a same side may be arranged in at least one of the following shapes: a straight line shape, a fold line shape, an arc shape, a wave shape, and a circular shape. It should be understood that the foregoing arrangement shapes are merely examples for description. This is not limited in embodiments of this application.

FIG. 5 is a diagram of structures of disposing positions of the at least one protrusion structure 240 according to still another embodiment of this application. For example, the protrusion structure 240 is a cuboid (or referred to as a retaining wall structure). As shown in (a) in FIG. 5, the at least one protrusion structure 240 is distributed in the first region 310 of the package baseplate 220 in a straight-line shape. As shown in (b) in FIG. 5, the at least one protrusion structure 240 is distributed in the first region 310 of the package baseplate 220 in a fold line shape.

It should be understood that the foregoing description is merely an example for description. For example, the at least one protrusion structure 240 may be a cylinder distributed in the first region 310 of the package baseplate 220 in the straight line shape or the fold line shape. This is not limited in embodiments of this application.

Optionally, in a possible implementation, the at least one protrusion structure 240 disposed on a same side may be arranged in a single row or a plurality of rows. It should be understood that this is not limited in embodiments of this application.

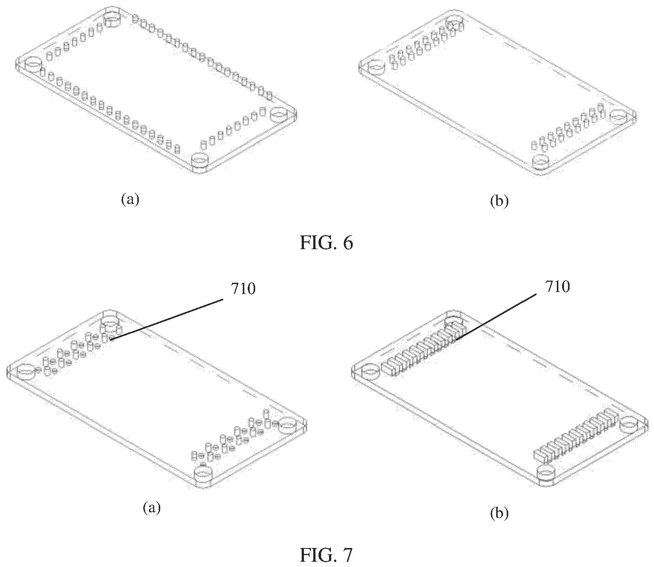

FIG. 6 is a diagram of structures of disposing positions of the at least one protrusion structure 240 according to still another embodiment of this application. For example, the protrusion structure 240 is a cylinder (or referred to as a microcolumn). As shown in (a) in FIG. 6, the at least one protrusion structure 240 is distributed on the four sides of the first region 310 of the package baseplate 220 in a single-row arrangement manner. As shown in (b) in FIG. 6, the at least one protrusion structure 240 is distributed on two opposite sides of the first region 310 of the package baseplate 220 in a dual-row arrangement manner.

It should be noted that the foregoing arrangement manners are merely examples. It should be understood that the at least one protrusion structure 240 may alternatively be distributed on at least one side of the first region 310 of the package baseplate 220 in the single-row arrangement manner, or the at least one protrusion structure 240 may be distributed on at least one side of the first region 310 of the package baseplate 220 in the dual-row arrangement manner. This is not limited in embodiments of this application.

Optionally, in a possible implementation, the package baseplate 220 further includes a rough structure. Specifically, the rough structure is disposed on a part, not covered by the ceramic baseplate 230, of the surface that is of the package baseplate 220 and that is close to the ceramic baseplate 230.

The rough structure is disposed on the part, not covered by the ceramic baseplate 230, of the surface that is of the package baseplate 220 and that is close to the ceramic baseplate 230. It may be understood that at least one surface of the at least one protrusion structure 240 and/or a surface that is in the first region 310 of the package baseplate 220 and on which the at least one protrusion structure 240 is not disposed has the rough structure obtained through roughening.

Specifically, roughening processing may be performed on the at least one surface (a surface and/or a side surface that are/is away from the package baseplate 220) of the at least one protrusion structure 240 to form the surface rough structure, or roughening processing may be performed on the surface that is in the first region 310 of the package baseplate 220 and on which no protrusion structure 240 is disposed, to form the surface rough structure, or roughening processing may be simultaneously performed on the at least one surface of the at least one protrusion structure 240 and the surface that is in the first region 310 of the package baseplate 220 and on which no protrusion structure 240 is disposed, to form surface rough structures.

It should be noted that roughness of the surface rough structure obtained through roughening ranges from 10 µm to 100 µm. It should be understood that the foregoing range of the surface roughness is merely an example for description. This is not limited in embodiments of this application.

It should be further noted that, in this embodiment of this application, the rough structure may be prepared on the surface through laser scanning, or the rough structure may be prepared on the surface through chemical etching, or the rough structure may be prepared on the surface through sandblasting. It should be understood that the foregoing preparation methods are merely examples for description, and this is not limited in embodiments of this application.

FIG. 7 is a diagram of structures of the package baseplate 220 on which the protrusion structure 240 and a groove structure 710 are disposed according to still another embodiment of this application.

As shown in FIG. 7, the package baseplate 220 further includes at least one groove structure 710. Specifically, the at least one groove structure 710 is disposed in a region, not covered by the ceramic baseplate 230, of the surface that is of the package baseplate 220 and that is close to the ceramic baseplate 230, that is, the at least one groove structure 710 is disposed in the first region 310 of the package baseplate 220. In this case, the plastic package body 250 is further configured to fill the at least one groove structure 710, to implement combination with the package baseplate 220.

Optionally, in a possible implementation, at least one protrusion structure 240 is disposed between any two adjacent groove structures in the at least one groove structure 710.

For example, as shown in (a) in FIG. 7, one protrusion structure 240 is disposed between any two adjacent groove structures in the at least one groove structure 710. In this case, it may be understood that the groove structure 710 and the protrusion structure 240 are arranged alternately on at least one side of the first region 310 of the package baseplate 220.

For example, a plurality of protrusion structures 240 may alternatively be disposed between any two adjacent groove structures in the at least one groove structure 710. It may be understood that the groove structure 710 and the plurality of protrusion structures 240 are arranged alternately on at least one side of the first region 310 of the package baseplate 220.

Optionally, in a possible implementation, any groove structure in the at least one groove structure 710 is located on any side of any protrusion structure of the at least one protrusion structure 240. For example, as shown in (b) in FIG. 7, any groove structure in the at least one groove structure 710 is located on a same side of any protrusion structure of the at least one protrusion structure 240.

It should be understood that the foregoing examples are merely examples for describing disposing positions of the at least one groove structure 710 and the at least one protrusion structure 240. It should be understood that this is not limited in embodiments of this application.

It should be noted that, in this embodiment of this application, a cross section of the at least one groove structure 710 disposed in the first region 310 of the package baseplate 220 includes at least one of the following shapes: a circle, an ellipse, a triangle, and a polygon. It should be understood that this is not limited in embodiments of this application.

It should be further noted that the groove structure 710 may be prepared through stamping, or the groove structure 710 may be prepared through etching. It should be understood that the foregoing methods are merely examples for description, and this is not limited in embodiments of this application.

It should be further noted that, in this embodiment of this application, roughening processing may alternatively be performed on a concave surface of the at least one groove structure 710, to form the surface rough structure.

For example, the rough structure may be prepared on the concave surface of the at least one groove structure 710 through laser scanning, or the rough structure may be prepared on the concave surface of the at least one groove structure 710 through chemical etching, or the rough structure may be prepared on the concave surface of the at least one groove structure 710 through sandblasting. It should be understood that the foregoing rough structure preparation methods are merely examples for description. This is not limited in embodiments of this application.

According to the technical solutions of this application, the at least one protrusion structure is disposed on the surface that is of the package baseplate and that is close to the ceramic baseplate, and the chip, the ceramic baseplate, and the surface that is of the package baseplate and on which the at least one protrusion structure is disposed are disposed in the plastic package body, so that bonding force between the package baseplate and the plastic package body can be further increased. This resolves problems of delamination and cracking between the package baseplate and the plastic package body.

In embodiments of this application, "at least one" refers to one or more, and "a plurality of" refers to two or more. The term "and/or" describes an association relationship between associated objects and represents that three relationships may exist. For example, A and/or B may represent the following cases: Only A exists, both A and B exist, and only B exists. A and B may be singular or plural. The character "/" generally indicates an "or" relationship between the associated objects. "At least one of the following" and similar expressions refer to any combination of these terms, including any combination of single or plural terms. For example, at least one item of a, b, and c may indicate: a, b, c, a and b, a and c, b and c, or a, b, and c, where a, b, and c may be singular or plural. It may be clearly understood by a person skilled in the art that, for the purpose of convenient and brief description, for a detailed working process of the foregoing system, apparatus, and unit, refer to a corresponding process in the foregoing method embodiments. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, comprising a chip, a package baseplate, a ceramic baseplate, and a plastic package body, wherein
the chip is disposed on the ceramic baseplate, the package baseplate is disposed on a surface that is of the ceramic baseplate and that is away from the chip, and an area of the package baseplate is greater than an area of the ceramic baseplate;
the package baseplate comprises at least one protrusion structure, the at least one protrusion structure is located on a surface that is of the package baseplate and that is close to the ceramic baseplate, and projection of the at least one protrusion structure does not overlap projection of the ceramic baseplate in a thickness direction of the chip; and
the chip, the ceramic baseplate, and the surface that is of the package baseplate and on which the at least one protrusion structure is disposed are disposed in the plastic package body.

2. The power module according to claim 1, wherein the package baseplate comprises a rough structure, and the rough structure is disposed on a part, not covered by the ceramic baseplate, of the surface that is of the package baseplate and that is close to the ceramic baseplate.

3. The power module according to claim 1 or 2, wherein the at least one protrusion structure is disposed on at least one side of the ceramic baseplate.

4. The power module according to any one of claims 1 to 3, wherein the at least one protrusion structure is arranged in at least one of the following shapes:
a straight line shape, a fold line shape, an arc shape, a wave shape, and a circular shape.

5. The power module according to claim 4, wherein the at least one protrusion structure is arranged in a single-row arrangement manner or a multi-row arrangement manner.

6. The power module according to any one of claims 1 to 4, wherein the package baseplate comprises at least one groove structure, and the at least one groove structure is disposed on the part, not covered by the ceramic baseplate, of the surface that is of the package baseplate and that is close to the ceramic baseplate.

7. The power module according to claim 6, wherein the at least one protrusion structure is disposed between any two adjacent groove structures in the at least one groove structure.

8. The power module according to claim 6 or 7, wherein a cross section of the groove structure comprises at least one of the following shapes:
a circle, an ellipse, a triangle, and a polygon.

9. The power module according to any one of claims 1 to 8, wherein the at least one protrusion structure comprises at least one of the following:
a cylinder, a prism, a cuboid, and a cube.

10. The power module according to any one of claims 1 to 9, wherein an interface area of a side that is of the at least one protrusion structure and that is close to the package baseplate is less than an interface area of a side that is of the at least one protrusion structure and that is away from the package baseplate; or
an interface area of a side that is of the at least one protrusion structure and that is close to the package baseplate is greater than an interface area of a side that is of the at least one protrusion structure and that is away from the package baseplate.

11. A power supply apparatus, comprising a circuit board and the power module according to any one of claims 1 to 10, wherein the power module is disposed on the circuit board.
